(19) Europäisches Patentamt
European Patent Office
Office européen des brevets

(11) Publication number : 0 278 628 B1

(12) # EUROPEAN PATENT SPECIFICATION

(45) Date of publication of patent specification : 03.07.91 Bulletin 91/27

(51) Int. Cl.$^5$ : C09K 13/08, H01L 21/31

(21) Application number : 88300653.8

(22) Date of filing : 27.01.88

(54) **Etching solutions containing ammonium fluoride.**

(30) Priority : 27.01.87 US 7067
27.01.87 US 7046

(43) Date of publication of application : 17.08.88 Bulletin 88/33

(45) Publication of the grant of the patent : 03.07.91 Bulletin 91/27

(84) Designated Contracting States : BE DE FR GB IT NL

(56) References cited :
EP-A- 201 800
DE-A- 1 964 611
FR-A- 2 374 396
US-A- 2 213 477

(56) References cited :
PATENT ABSTRACTS OF JAPAN, vol. 7, no. 143 (C-172)[1288], 22nd June 1983; & JP-A-58 55 324 (TOKYO SHIBAURA DENKI K.K.) 01-04-1983

(73) Proprietor : OLIN CORPORATION
350 Knotter Drive P.O. Box 586
Cheshire, CT 06410-0586 (US)

(72) Inventor : Scardera, Michael
81 Manor Street
Hamden Connecticut 06517 (US)
Inventor : Roche, Thomas Stephen
375 Redwood Lane
Cheshire Connecticut 06410 (US)

(74) Representative : Thomas, Roger Tamlyn et al
D. Young & Co. 10 Staple Inn
London WC1V 7RD (GB)

EP 0 278 628 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to etching solutions used in the manufacture of integrated circuits. More particularly this invention relates to etching solutions containing wetting agents to properly wet substrates of components in the manufacture of integrated circuits.

As integrated circuit component dimensions become small, physical wetting by etchant solutions on substrate surfaces becomes more difficult.This is especially important for buffered oxide etchants i.e., ammonium fluoride/hydrofluoric acid solutions used in silicon dioxide etching. These solutions exhibit extremely high surface tension values of 85 to 90 dynes/cm at typical etching temperatures. Because of the relatively low surface energies of the masking materials used and the photoresist topography, it is difficult to properly wet the substrate, which results in non-uniform etching and poor line reproduction.

While pretreatment ("predipping") of the component into a surfactant solution before placing the substrates in the etching solution is known, more satisfactory results are obtained by the addition of the wetting agent to the etching solution. However, most surfactants commonly used in the industry are insoluble in buffered oxide etchant solutions containing ammonium fluoride and hydrofluoric acid. Further, sufficiennt amounts of the wetting agent must remain in the etching solution after filtration through filters on the order of 0.2 microns to provide the desired wetting of the substrates during the etching process.

Wetting agents containing fluorochemical compounds have been employed as additives to $NH_4F/HF$ etching solutions to improve wetting properties. Examples of fluorochemical compounds include perfluorinated alkyl sulfonates described in U.S. Patent US-A-4,517,106, issued May 14, 1985, and fluorinated cycloalkane and cycloalkene sulfonates taught in U.S. Patent US-A-4,620,934, issued November 4, 1986 to R.J. Hopkins et al; fluorine-containing carboxylic acids described in U.S. Patent US-A-4,582,624, issued April 15, 1986 to N. Enjo et al ; and fluorine-containing diamine compounds as described in Japanese Patent Kokaï Publication No. 53.980/1983 published March 30, 1983 of Daikin Kogyo KK. These surfactants may incorporate metallic ions with the etching solution and in addition are expensive.

There is a need for wetting agents which are readily soluble in buffered etching solutions containing ammonium fluoride (and preferably hydrogen fluoride), which will not incorporate metallic ions in their structure, and which provide good wetting properties over extended periods of time at reduced costs.

The present invention provides an etching solution comprising an aqueous solution of ammonium fluoride and a wetting amount of a nonionic wetting agent selected from an alkylphenol polyglycidol ether having the formula :

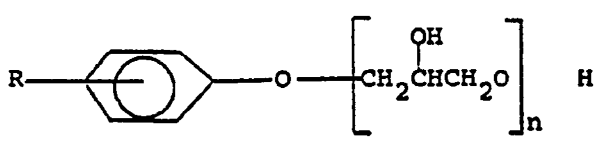

(I)

wherein R is an alkyl group having from 4 to 12 carbon atoms and n is from 3 to 15 ; and an alkyl polysaccharide having the formula :

$$R'O(R''O)_xZ_y$$

wherein R' is alkyl, alkylphenyl, hydroxyalkyl, hydroxy alkylphenyl, or mixtures thereof and the alkyl groups contain from 6 to 18 carbon atoms, R" is an alkyl group which contains from 1 to 4 carbon atoms, x is from 0 to 5, z is a moiety derived from a reducing saccharide containing from 5 to 6 carbon atoms, and y is from 1 to 5.

The present invention also provides a process for etching silicon dioxide substrates using such a solution and having desirable etching rates.

Preferred features of the invention will now be described.

In more detail, the nonionic wetting agents used in the novel etching solutions of the present invention include alkylphenol polyglycidol ethers having the above formula in which the alkyl groups are, for example, butyl, hexyl, octyl, nonyl, and dodecyl. Preferred embodiments include those in which R has from 8 to 12 carbon atoms and includes octyl, nonyl, and dodecyl groups, and n is from 6 to 12. In a more preferred embodiment, R is primarily in the para position. It is noted that the n number represents an average number of glycidol units per alkylphenol unit. Surfactants of the above type (I) are commercially available and may be prepared by well-known methods as illustrated, for example, in U.S. Patents US-A-2,213,477 and US-A-2,233,281.

The alkylpolysaccharides which are useful as wetting agents in the etching solutions of this invention having the formula :

$$R'O(R''O)_xZ_y$$

include those having a hydrophobic group R′ containing from 6 to 24 carbon atoms, preferably from 6 to 18 carbon atoms, more preferably from 8 to 14 carbon atoms. Preferably, the hydrophobic group is in an alkyl group either saturated or unsaturated, branched or unbranched, and more preferably unbranched and saturated. The alkyl group can contain up to three hydroxyl groups as substituents. Optionally and less desirably there can be a polyalkoxide, R′O, preferably a polyethoxide chain joining the hydrophobic group and the polysaccharide moiety. The polyalkoxide chain can contain up to 3, preferably 1, and most preferably no alkoxide moieties.

The polysaccharide portion of the alkylpolysaccharide wetting agent is derived from reducing saccharides containing from 5 to 6 carbon atoms each. Examples of reducing saccharide moieties include, galactose, glucose, fructose, glucosyl, fructosyl, and/or galactosyl moieties. Glucose is preferred. It is essential that the average polysaccharide chain average from 1 to 5, preferably from 1 to 2 1/2, more preferably from 1 to 2 saccharide units. Preferably the amount of alkylmonosaccharide present is form 30 percent to 90 percent, more preferably from 40 percent to 80 percent, and the amount of alkyl polysaccharides having saccharide chains greater than 2 is preferably less than 10 percent, more preferably less than 5 percent, most preferably less than 2 percent. The saccharide moieties are normally and preferably attached to the hydrophobic group through the 1-position, but the hydrophobic group can be attached at, e.g., the 2-, 3-, 4-, or 6-positions, thus giving, e.g., a glucose or galactose as opposed to a glucoside or a galactoside. The additional saccharide units can be attached to the previous saccharide unit's 2-, 3-, 4-, and 6-positions.

Alkyl polysaccharides suitable as wetting agents can be produced by processes described in U.S. Patents US-A-3,219,656 ; US-A-3,598,865 ; US-A-3,721,633 ; and US-A-3,772,269 among others. These wetting agents are commercially available, for example, from Rohm & Haas (Tradename : Triton BG-10®) and Horizon Chemicals (Tradename : APG® surfactants).

These liquid nonionic wetting agents are employed in any suitable wetting amounts which, in the buffered oxide etching solutions, will enhance the wetting of the substrate to be etched. Suitable amounts include those in the range of from 5 to 50,000 parts per million by weight, preferably from 25 to 30,000, and more preferably from 50 to 5,000 parts per million.

Etching solutions of the present invention have been found to retain their wetting properties after 0.2 micron filtration, even under continuous filtration conditions. Moreover, the etching solutions after filtering have the property of wetting substrates more effectively and yield more uniform results by etching small geometries (1 to 5 microns) and large geometries (> 5 micron) of silicon dioxide in a patterned resist at the same rate without additional deleterious effects. Further, the nonionic wetting agents do not incorporate metallic ions in their structure.

The preferred etching solutions of the present invention, as buffered oxide etchants, are aqueous solutions of ammonium fluoride having a concentration of between 15 percent and 40 percent by weight of $NH_4F$. Admixed with the ammonium fluoride is an aqueous solution of hydrogen fluoride in amounts which provide the buffered oxide etchant with at least 3 parts by volume of $NH_4F$ to 1 part by volume of HF and up to 50 parts by volume of $NH_4F$ to 1 part by volume of HF. In preparing the buffered oxide etching solutions of the present invention, commercially available concentrated aqueous solutions of $NH_4F$ (normally about 40 percent by weight) and HF (normally about 49 percent by weight) may be employed.

The etching solution of the present invention may be prepared in any suitable manner. For example, an aqueous solution of ammonium fluoride and the wetting agent may be prepared and the hydrogen fluoride then added ; the aqueous solutions of ammonium fluoride and hydrogen fluoride and the liquid nonionic wetting agent may be simultaneously blended or the aqueous mixture of ammonium fluoride and hydrogen fluoride prepared and the liquid wetting agent then blended in.

Other additives normally used in buffered oxide etchant solutions may be included in the novel etching solutions of the present invention. For example, polar solvent diluents such as acetic acid, ethylene glycols, glycerol, and lower alkyl alcohols having from 1 to 4 carbon atoms may be included.

The etching solutions are used to etch silicon dioxide coated substrates in the manufacture of integrated circuits employing methods and procedures known in the semiconductor industry.

Etching solutions of the present invention have been found to provide etchant solutions with reduced surface tensions after microfiltration which improves substrate wetting and yields superior etchant performance resulting in cleaner surfaces and greater uniformity of etched profiles without incorporating foreign metallic ions. The solutions are stable and have desirable shelf lives without phase separations of the wetting agent from the $NH_4F$ and HF components.

The following examples illustrate the present invention with no intention of being limited thereby.

EXAMPLE 1

A buffered oxide etching aqueous solution was prepared containing 7 parts by volume of ammonium fluoride and 1 part by volume of hydrogen fluoride. To 500 grams of the etchant solution was added 500 parts per million of a liquid nonionic nonylphenol polyglycidol ether containing about 10 glycidol units (Olin Glycidol Surfactant-10 G®) as the wetting agent. The surface tension of the etching solution was measured with a Du Nouy Ring Tensiometer at 25°C. The solution was filtered through a 0.2 micron polytetrafluoroethylene filter (Millipore) and the surface tension measured again. The results are shown in TABLE I below.

EXAMPLE 2

The procedure of EXAMPLE 1 was repeated exactly with the sole exception that a liquid nonionic octyl/decyl glucoside (Rohm & Haas Triton BG-10®) was employed as the wetting agent. The results are shown in TABLE I below.

Comparative Examples A, B and C

The procedure of EXAMPLES 1 and 2 was repeated exactly without the addition of a wetting agent and with the substitution of anionic wetting agents ammonium perfluoroalkyl sulfonate (Fluorad® FC-93 3M Co. and potassium perfluoroalkyl sulfonate (Fluorad® FC-98 3M Co.) for the wetting agents of EXAMPLES 1 and 2. The results are shown in TABLE I below.

TABLE I

| Example No. | Wetting Agent | Surface Tension (dynes/cm) Before Filtration | After Filtration |
|---|---|---|---|
| 1 | Nonylphenol polyglycidol ether | 30.8 | 32.3 |
| 2 | Octyl/decyl glucoside | 29.1 | 29.3 |
| Comparative A | None | 82.3 | 82.3 |
| Comparative B | Fluorad® FC-93 | 21.1 | 79.0 |
| Comparative C | Fluorad® FC-98 | 21.2 | 43.2 |

TABLE I shows that the loss of wetting activity, as indicated by an increase in surface tension, is only slight after the filtration of the etching solutions of EXAMPLES 1 and 2 illustrating the etching solutions of the present invention. For Comparative Examples A, B and C, however, after filtration there is a substantial increase in the surface tension indicating a significant loss of wetting activity.

EXAMPLES 3-4

Buffered etching solutions (800 mls) having an $NH_4F$ : HF volume ratio of 7 : 1 containing 200 parts per million of nonylphenol polyglycidol ether (Olin Glycidol Surfactant-10G®) or octyl/decyl glucoside (Rohm and Haas Triton BG-10®) were prepared. Each of the buffered etching solutions was continuously passed through a 0.2 micron filter at a rate of 800 mls per minute for a period of 6.5 hours. The surface tension of the etching solution was measured before filtering and after completion of the filtering period. The results are shown in TABLE II below :

TABLE II

| Example No. | Wetting Agent | Surface Tension (dynes/cm) Before Filtration | After Filtration |
|---|---|---|---|
| 3 | Nonylphenol polyglycidol ether | 31.2 | 39.5 |
| 4 | Octyl/decyl glucoside | 29.7 | 32.2 |

This example shows that the loss of wetting activity of the etching solutions of the present invention after continuous filtration over an extended period of time is small.

EXAMPLE 5

Four inch (about 10 cm) silicon wafers were oxidized thermally to about 6000 A, (determined by ellipsometry) coated with positive photoresist to a thickness of about 1.2 microns, and patterned with masks having geometries of about 1.6 to about 2 microns. The etch time was then calculated. One wafer was immersed in a buffered oxide etching solution having an $NH_4F$ : HF volume ratio of 7 : 1 and containing 200 parts per million of nonylphenol polyglycidol ether (Olin Glycidol Surfactant-10G®). The etching, at 25°C, was conducted until the 100 percent etch time, as calculated, was attained. The etched pattern was then rinsed in water. The wafer was then inspected with a light microscope with a magnification in the range of 400X to 1000X. The results are shown in TABLE III below.

Comparative Examples D, E and F

The procedure of EXAMPLE 2 was repeated exactly with three 4 inch (about 10 cm) silicon wafers. The patterned wafers were immersed in a buffered oxide etching solution (volume ratio 7 : 1 of $NH_4F$ : HF) which contained no wetting agent for etch times of 100 percent, 105 percent, and 110 percent. The etched wafers were then rinsed in water and inspected using the procedure of EXAMPLE 5. The results are given in TABLE III below.

TABLE III

Percent of Completely Etched Geometries

| Example No. | % of Etch Time | 2 Micron | 1.8 Micron | 1.6 Micron |
|---|---|---|---|---|
| 5 | 100% | 100 | 100 | 100 |
| Comparative D | 100% | 63 | 51 | 42 |
| Comparative E | 105% | 98 | 95 | 89 |
| Comparative F | 110% | 100 | 100 | 98 |

EXAMPLE 6

Four inch (about 10 cm) silicon wafers were oxidized thermally to about 6000 A, (determined by ellipsometry) coated with positive photoresist to a thickness of about 1.2 microns, and patterned with masks having geometries of about 1.7 to about 5.0 microns. The etch time was then calculated. One wafer was immersed in

a buffered oxide etching solution having an $NH_4F$ : HF volume ratio of 7 : 1 and containing 200 parts per million of octyl/decyl glucoside (Rohm & Haas Triton BG-10®) as the wetting agent. The etching, at 25°C, was conducted until the 100 percent etch time, as calculated, was attained. The etched pattern was then rinsed in water. The wafer was then inspected with a light microscope with a magnification in the range of 400X to 1000X. The results are shown in TABLE IV below.

Comparative Example G

The procedure of EXAMPLE 2 was repeated exactly with another silicon wafer. The patterned wafer was immersed in a buffered oxide etching solution (volume ratio 7 : 1 of $NH_4F$ : HF) which contained no wetting agent for the same etch time calculated for EXAMPLE 2. The etched wafer was then rinsed in water and inspected using the procedure of EXAMPLE 2. The results are given in TABLE IV below.

TABLE IV

Percent of Completely Etched Geometries

| Example No. | % of Etch Time | 5.0 Micron | 3.5 Micron | 2.0 Micron | 1.7 Micron |
|---|---|---|---|---|---|
| 6 | 100% | 100 | 100 | 100 | 100 |
| Comparative G | 100% | 100 | 87 | 77 | 67 |

EXAMPLES 5 and 6 illustrate that the etching solutions of the present invention etch small geometries completely within the desired etch time without requiring overetching which results in the loss of pattern definition.

EXAMPLE 7

Solutions of buffered oxide etchant containing a volume ratio of $NH_4F$ to HF of 7 : 1 were prepared containing 5 parts per million and 100 parts per million of nonylphenol polyglycidol ether (Olin Surfactant-10G®) and of octyl/decyl glucoside (Rohm and Haas Triton BG-10®) as wetting agents. The surface tension of the solutions was measured using the method of EXAMPLE 1. The solutions were poured into a container which was sealed and stored at ambient temperatures for 6 months. Periodically the containers were opened and the surface tension of each solution measured. The final results are given in TABLE V below.

TABLE V

| Wetting Agent | Concentration (ppm) | Surface Tension (dynes/cm) Initial | After 6 Months |
|---|---|---|---|
| Nonylphenol polyglycidol ether | 100 | 33.5 | 33.2 |
| Nonylphenol polyglycidol ether | 5 | 57.2 | 59.7 |
| Octyl/decyl glucoside | 100 | 30.4 | 29.9 |
| Octyl/decyl glucoside | 5 | 54.9 | 56.7 |

This example shows that the etching solutions of the present invention are stable and retain their wetting properties over extended periods of time.

## Claims

1. An etching solution comprising an aqueous solution of ammonium fluoride and a wetting amount of a nonionic wetting agent selected from an alkylphenol polyglycidol having the formula :

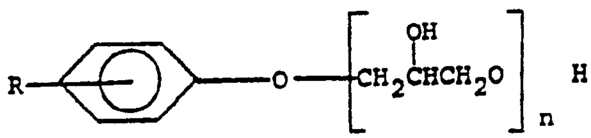

(I)

wherein R is an alkyl group having from 4 to 12 carbon atoms and n is from 3 to 15, and an alkyl polysaccharide having the formula :

$$R'O(R''O)_xZ_y$$

wherein R' is alkyl, alkylphenyl, hydroxyalkyl, hydroxy alkylphenyl, or mixtures thereof and the alkyl groups contain from 6 to 18 carbon atoms, R" is an alkyl group which contains from 1 to 4 carbon atoms, x is from 0 to 5, Z is a moiety derived from a reducing saccharide containing from 5 to 6 carbon atoms, and y is from 1 to 5.

2. The etching solution of claim 1 in which the ammonium fluoride is present in a concentration of from about 15 to 40 percent by weight.

3. The etching solution of claim 1 or 2 in which hydrogen fluoride is present and the volume ratio of $NH_4F$ to HF is from 3 : 1 to 50 : 1.

4. The etching solution of claim 1, 2 or 3 in which the wetting amount is from 5 to 50,000 parts per million by weight.

5. The etching solution of claim 4 in which the nonionic wetting agent is an alkylphenol polyglycidol ether wherein n is from 6 to 12.

6. The etching solution of claim 5 in which R has from 8 to 12 carbon atoms.

7. The etching solution of claim 6 in which the alkylphenol polyglycidol ether is a nonylphenol polyglycidol ether.

8. The etching solution of claim 4 in which the wetting agent is an alkyl polysaccharide in which R' is an alkyl group having from 8 to 14 carbon atoms.

9. The etching solution of claim 8 in which x is 0 or 1.

10. The etching solution of claim 9 in which y is from 1 to 2 1/2.

11. The etching solution of claim 10 in which x is 0, and y is from 1 to 2.

12. The etching solution of any preceding claim in which the wetting amount is from 25 to 30,000 parts per million by weight.

13. A process for etching a silicon dioxide coated substrate which comprises immersing the substrate in the etching solution of any preceding claim.

## Ansprüche

1. Ätzlösung, welche eine wäßrige Ammoniumfluoridlösung und eine benetzende Menge eines nicht-ionischen Netzmittels enthält, das ausgewählt ist aus Alkylphenol-polyglycidolen der Formel (I)

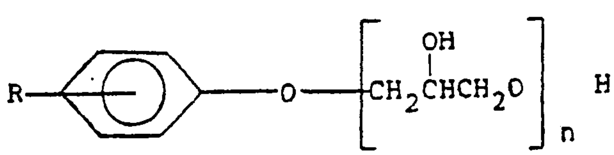

(I),

worin R eine Alkylgruppe mit 4 bis 12 Kohlenstoffatomen ist, und n 3 bis 15 beträgt, und aus Alkylpolysacchariden der Formel

$$R'O(R''O)_xZ_y$$

worin R' Alkyl, Alkylphenyl, Hydroxyalkyl, Hydroxyalkylphenyl oder Mischungen davon ist, und die Alkylgruppen 6 bis 18 Kohlenstoffatome enthalten, R" eine Alkylgruppe ist, die 1 bis 4 Kohlenstoffatome enthält, x 0 bis 5 beträgt, Z ein von einem reduzierenden Saccharid hergeleiteter Bestandteil ist, der 5 bis 6 Kohlenstoffatome enthält, und Y 1 bis 5 beträgt.

2. Ätzlösung nach Anspruch 1, bei welcher das Ammoniumfluorid in einer Konzentration von 15 bis 40 Gew.-% vorliegt.

3. Ätzlösung nach Anspruch 1 oder 2, in welcher Fluor-Wasserstoff zugegen ist und das Volumenverhältnis von $NH_4F$ zu HF 3 : 1 bis 50 : 1 beträgt.

4. Ätzlösung nach Anspruch 1, 2 oder 3, bei welcher die benetzende Menge 5 bis 50.000 Gew.-Teile pro Mio. beträgt.

5. Ätzlösung nach Anspruch 4, bei welcher das nichtionische Netzmittel ein Alkylphenol-polyglycidolether ist, bei dem n 6 bis 12 beträgt.

6. Ätzlösung nach Anspruch 5, bei der R 8 bis 12 Kohlenstoffatome hat.

7. Ätzlösung nach Anspruch 6, bei der der Alkylphenol-polyglycidolether ein Nonylphenol-polyglycidolether ist.

8. Ätzlösung nach Anspruch 4, bei der das Netzmittel ein Alkylpolysaccharid ist, bei dem R' eine Alkylgruppe mit 8 bis 14 Kohlenstoffatomen ist.

9. Ätzlösung nach Anspruch 8, bei der x = 0 oder 1 ist.

10. Ätzlösung nach Anspruch 9, bei der y 1 bis 2 1/2 beträgt.

11. Ätzlösung nach Anspruch 10, bei der x = 0 ist und y 1 bis 2 beträgt.

12. Ätzlösung nach einem der vorhergehenden Ansprüche, bei der die benetzende Menge 25 bis 30.000 Gew.-Teile pro Mio. beträgt.

13. Verfahren zum Ätzen eines mit Siliciumdioxid beschichteten Substrats, welches das Eintauchen des Substrats in die Ätzlösung nach einem der vorhergehenden Ansprüche einschließt.

## Revendications

1. Une solution de gravure comprenant une solution aqueuse de fluorure d'ammonium et une quantité efficace d'un agent mouillant non ionique choisi parmi un alkylphénolpolyglycidoléther ayant la formule :

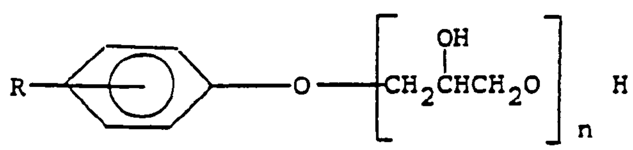

(I)

dans laquelle R est un groupe alkyle ayant de 4 à 12 atomes de carbone et n est de 3 à 15, et un alkylpolysaccharide ayant la formule :

$$R'O(R''O)_xZ_y$$

dans laquelle R' est un groupe alkyle, alkylphényle, hydroxyalkyle, hydroxyalkylphényle, ou leurs mélanges et les groupes alkyles contiennent de 6 à 18 atomes de carbone, R" est un groupe alkyle qui contient de 1 à 4 atomes de carbone, x est de 0 à 5, Z est une moitié dérivée d'un saccharide réducteur contenant de 5 à 6 atomes de carbone, et y est de 1 à 5.

2. La solution de gravure selon la revendication 1, dans laquelle le fluorure d'ammonium est présent à une concentration de 15 à 40% en poids.

3. La solution de gravure selon la revendication 1 ou 2, dans laquelle l'acide fluorhydrique est présent et le rapport volumique de $NH_4F$ : HF est de 3 : 1 à 50 : 1.

4. La solution de gravure selon la revendication 1, 2 ou 3, dans laquelle la quantité d'agent mouillant est de 5 à 50000 parties par million en poids.

5. La solution de gravure selon la revendication 4, dans laquelle l'agent mouillant non ionique est un alkylphénolpolyglycidoléther dans lequel n est de 6 à 12.

6. La solution de gravure selon la revendication 5, dans laquelle R a de 8 à 12 atomes de carbone.

7. La solution de gravure selon la revendication 6, dans laquelle l'alkylphénolpolyglycidoléther est un nonylphénolpolyglycidoléther.

8. La solution de gravure selon la revendication 4, dans laquelle l'agent mouillant est un alkylpolysaccharide dans lequel R' est un groupe alkyle ayant de 8 à 14 atomes de carbone.

9. La solution de gravure selon la revendication 8, dans laquelle x est égal à 0 ou 1.

10. La solution de gravure selon la revendication 9, dans laquelle y est de 1 à 2 1/2.

11. La solution de gravure selon la revendication 10, dans laquelle x est 0, et y est de 1 à 2.

12. La solution de gravure selon l'une quelconque des revendications précédentes, dans laquelle la quantité d'agent mouillant est de 25 à 30 000 parties par million en poids.

13. Un procédé de gravure d'un substrat revêtu de dioxyde de silicium qui comprend l'immersion du substrat dans la solution de gravure selon l'une quelconque des revendications précédentes.